(19) Europäisches Patentamt
European Patent Office
Office européen des brevets

(11) **EP 2 608 410 B1**

(12) **EUROPEAN PATENT SPECIFICATION**

(45) Date of publication and mention
of the grant of the patent:
**06.08.2014 Bulletin 2014/32**

(51) Int Cl.:
*H03K 7/08* (2006.01)          *H03F 1/32* (2006.01)
*H03F 3/217* (2006.01)        *H03F 3/189* (2006.01)
*H03F 3/24* (2006.01)

(21) Application number: **11306718.5**

(22) Date of filing: **21.12.2011**

(54) **A method for pulse width modulation of signals, and a transmitter therefor**

Verfahren zur Pulsweitenmodulation von Signalen und Sender dafür

Procédé de modulation à largeur d'impulsions de signaux et transmetteur associé

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.06.2013 Bulletin 2013/26**

(73) Proprietor: **Alcatel Lucent**
**75007 Paris (FR)**

(72) Inventors:
• **Frotzscher, Andreas**
**01640 Coswig (DE)**

• **Markert, Daniel**
**70435 Stuttgart (DE)**
• **Haslach, Christoph**
**70178 Stuttgart (DE)**

(74) Representative: **Kleinbub, Oliver et al**
**Alcatel-Lucent Deutschland AG**
**Intellectual Property & Standards**
**Lorenzstrasse 10**
**70435 Stuttgart (DE)**

(56) References cited:
**WO-A1-82/04507          WO-A2-2006/020503**
**CA-A1- 1 174 301          US-A- 3 363 199**
**US-A1- 2009 027 117**

EP 2 608 410 B1

**Description**

**Field of the invention**

The invention relates to a method for pulse width modulation of signals, and a transmitter adapted to perform said method.

**Background**

Conventional linear power amplifiers suffer from poor energy efficiency. In contrast to this, switching power amplifiers provide very high energy efficiency, but require discrete amplitude signals.

In order to support these highly efficient switching power amplifiers, band limited transmit signals with continuous amplitude, or multi-level signals, need to be converted to discrete 2-level signals. In general, this transformation is executed by so-called delta sigma modulators (DSM), also called sigma delta modulators, or pulse length modulators (PLM), also called pulse width modulators. The resulting discrete signals are amplified by a switching power amplifier.

These so-called pulse width modulators (PWM) are promising modulator concepts e.g. for highly efficient switching power amplifiers used for the amplification of radio signals to be transmitted over an air interface in a communication network. In principle, they allow for an ideal conversion of signals with continuous amplitude and limited bandwidth to a time continuous 2-level signal. This 2-level signal is perfectly suited for switching amplifier stages. The 2-level signal can be re-converted to the continuous amplitude signal simply by a reconstruction filter after the amplification stage.

Further applications of pulse width modulators comprise the control of the supply of electrical power for other devices such as in speed control of electric motors, operation of so-called class-D audio switching amplifiers or brightness control of light sources.

In the US patent 3,363,199 A, a method for pulse width modulation using a high-frequency sinusoidal waveform as a non-linear reference signal is disclosed.

In the US patent application publication US 2009/0027117 A1, systems and methods for performance improvements in a digital switching power amplifier by reducing noise and distortion are disclosed. In embodiments of the invention, a pulse width modulator is used, and a predistortion unit, a low-pass filter, a simulator, or a low-delay corrector is used to correct amongst others nonlinearity errors originated in the pulse width modulator. Said predistortion unit is designed to invert nonlinear aspects of the combination of the low-delay corrector and the simulator.

In the international patent application publication WO 82/04507 A1, an amplitude modulator is disclosed which uses a pulse width modulator. To prevent nonlinear operation, the modulation signal is modified in a correction amplifier applying a correction based on the modulation signal in order to allow the carrier signal to vary linearly with the modulation signal.

In the international patent application publication WO 2006/020503 A2, a read back circuit using a look-up-table for generation of an anti-distortion signal which is added to the input signal for a switching power stage using a PWM modulator is disclosed.

**Summary**

There exist numerous pulse width modulator architectures, but they either suffer from low coding efficiency, spectral deterioration, high sampling frequencies and/or difficulties in implementations. The typical class S setup for radio frequency (RF) applications employing a pulse width modulator looks as follows: an analogue signal is converted to a 2-level, i.e. binary, signal, e.g. a switching signal, by a pulse width modulator. The resulting signal is amplified by a switching amplifier. The amplified signal is re-converted to a time- and amplitude-continuous signal by a reconstruction filter, which can be a low pass or band pass filter depending on the spectral pureness and the wanted signal band. This filter erases, i.e. attenuates, the out-of-band signal components. If there are many and strong out-of-band signal components, also refered to as quantization noise, this results in strict requirements for the filter characteristics and the termination conditions of this filter. Any non-idealities in these characteristics result in power losses and/or spectral deterioration. Hence, it is important to have a pulse width modulator architecture, that generates a switching signal with a minimum of signal components in the out-of-band region. This means, the coding efficiency of the switching signal, defined as the ratio of the wanted signal power at the carrier frequency and the total signal power of the switching signal, shall be as high as possible.

In general, a pulse width modulator can achieve much better spectral purity and better coding efficiency than a delta sigma modulator. Therefore the pulse width modulator is a promising modulator for the switch mode amplification concept.

In principle, an analogue implementation of a pulse width modulator works as described in the following.

A signal with a continuous amplitude $S(t)$ is fed to a comparator as a first input signal. The second input signal $SR(t)$, referred to as reference signal in the following, fed to the comparator is a sawtooth signal or a triangular signal.

In the following only the sawtooth signal is mentioned, but the considerations are valid for triangular signals too. As soon as the ascending amplitude of the sawtooth signal SR(t) has the same value as the continuous amplitude signal S(t), the output of the comparator switches from voltage-high (VH) to voltage-low (VL). As soon as the descending amplitude of the sawtooth signal SR(t) has the same value as the continuous amplitude signal S(t), the output of the comparator switches from voltage-low (VL) to voltage-high (VH). The output of the comparator is the PWM signal. Without loss of generality, the values VH and VL may be chosen to arbitrary different levels to modify the properties of the PWM output signal.

Depending on the implementation, the first input signal S(t) of the comparator may also be the sampled version of the continuous amplitude signal, sampled at equidistant time instances.

The modulation index of the pulse width modulator can be expressed by the so-called Peak Power Backoff (PBO), describing the peak signal power ratio between the reference signal SR(t) and the information signal S(t)

$$PBO = \frac{\max\left(|SR(t)|^2\right)}{\max\left(|S(t)|^2\right)} \ .$$

Consequently, the coding efficiency decreases with increasing PBO and vice versa.

The performance of pulse width modulators suffer from several problems, above all distortions of the reference signals and device imperfections of the pulse width modulators.

Reference signal distortions:

In order to achieve a linear relation between the input amplitude S(t) of the pulse width modulator and the output pulse width, the reference signal SR(t) has to be a periodic triangular or sawtooth signal. However, such reference signals comprise spectral components at several multiples of the fundamental frequency of the reference signal SR(t). Especially for the pulse width modulation of radio frequency (RF) signals with carrier frequencies in the GHz range, adequate reference signals are difficult to generate and force extremely high bandwidth of the pulse width modulator and the subsequent amplifier stages.

Device imperfections of pulse width modulators:

Since the pulse width modulator device is implemented by analogue circuitry, it suffers from several imperfections, e.g. limited bandwidth, switching hysteresis, asymmetric switching behaviour, e.g. transition from voltage-high (VL) to voltage-low (VH) compared to transition from voltage-low (VL) to voltage-high (VH).

The limited frequency bandwidth of the pulse width modulator upper bounds the slew rate of the pulse width modulator output pulse sequence. Especially short positive or negative pulses might not reach the HIGH level VH or LOW level VL, respectively. This effect introduces distortions to the pulse width modulation and deteriorates the quality of the transmit signal at the output of the reconstruction filter and the performance of the switch-mode amplification concept.

The object of the invention is thus to propose a method for pulse width modulation of signals with a high signal quality and coding efficiency and at the same time with relaxed requirements on the reference signal generation and on the pulse width modulator.

The basic idea of the invention is to use non-linear reference signals for pulse width modulation, which can be easier generated than linear reference signals, and to precompensate distortions caused by the non-linear reference signals before the pulse width modulation.

The object is thus achieved by a method for pulse width modulation according to claim 1.

The object is furthermore achieved by a transmitter comprising at least one precompensation unit, and at least one pulse width modulator according to claim 10.

According to embodiments of the invention, the signal is additionally precompensated based on device imperfections of the pulse width modulator.

In the following the description focuses on binary, i.e. 2-level, pulse width modulators. However, this does not represent a limitation of the invention as presented below. The invention is applicable to binary, ternary and multi level pulse width modulators in general.

Further features and advantages are stated in the following description of exemplary embodiments, with reference to the figures, which show significant details, and are defined by the claims. The individual features can be implemented individually by themselves, or several of them can be implemented in any desired combination.

## Brief description of the figures

In the following the invention will be explained further making reference to the attached drawings.

Fig. 1 schematically shows a pulse width modulator according to the state of the art.

Fig. 2 schematically shows an input signal with a continuous amplitude, an output signal and a sawtooth reference signal of a pulse width modulator according to the state of the art.

Fig. 3 schematically shows an input signal which is a sampled version of a signals with a continuous amplitude, an output signal and a sawtooth reference signal of a pulse width modulator according to the state of the art.

Fig. 4 schematically shows a transmitter comprising a pulse width modulator using sinusoidal reference signals for signal modulation of an input signal.

Fig. 5 schematically shows a transmitter comprising a pulse width modulator with a modelling of bandpass distortions by sinusoidal reference signals performed by an equivalent bandpass distortion function.

Fig. 6 schematically shows a transmitter comprising a pulse width modulator with a modelling of bandpass distortions by sinusoidal reference signals performed by an equivalent bandpass distortion function, and with a modelling of a precompensation of the bandpass distortions performed by a bandpass precompensation function.

Fig. 7 schematically shows a transmitter comprising a precompensation unit, a pulse width modulator for signal modulation, and a switching power amplifier.

Fig. 8 schematically shows a transmitter comprising a precompensation unit, a pulse width modulator for signal modulation, and a switching power amplifier with feedback of information from the pulse width modulator to the precompensation unit.

Fig. 9 schematically shows a transmitter comprising a precompensation unit, a pulse width modulator for signal modulation, and a switching power amplifier with feedback of information from the pulse width modulator to the precompensation unit, and with feedback of a pulse width modulated signal to the precompensation unit.

Fig. 10 schematically shows a transmitter comprising a precompensation unit, a pulse width modulator for signal modulation, and a switching power amplifier with feedback of information from the pulse width modulator to the precompensation unit, and with feedback of an amplified pulse width modulated signal to the precompensation unit.

## Description of the embodiments

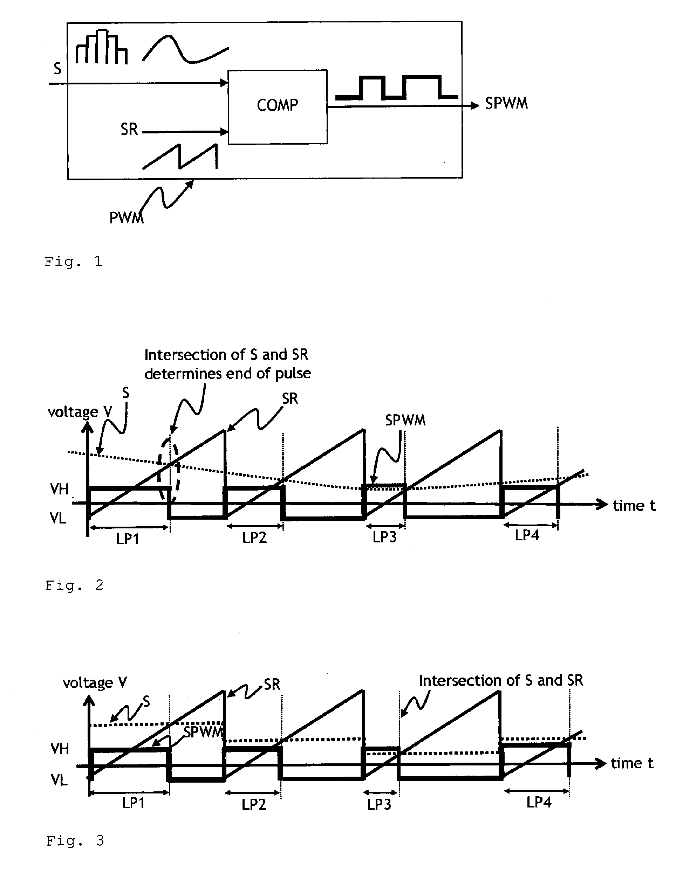

Fig. 1 schematically shows a pulse width modulator PWM according to the state of the art comprising as a basic part a comparator COMP with two inputs and one output.
Depending on the implementation, the input signal S of the pulse width modulator PWM can either be a signal with continuous amplitude, or the sampled version of the continuous amplitude signal, sampled at equidistant time instances.
The input signal S is fed to the first input of the comparator COMP, and a sawtooth signal SR is fed as reference signal to the second input of the comparator COMP. As soon as the ascending amplitude of the sawtooth signal SR has the same value as the input signal S, the output of the comparator switches from voltage-high (VH) to voltage-low (VL) and remains at VL as long as SR ≥ S holds. As soon as the descending amplitude of the sawtooth signal SR has the same value as the input signal S, the output of the comparator switches from voltage-low (VL) to voltage-high (VH) and remains at VH as long as SR < S holds. The pulse width modulated signal SPWM is transmitted from the output of the comparator COMP to the output of the pulse width modulator PWM.
Fig. 2 schematically shows such an input signal S, an output signal SPWM and a sawtooth signal SR of a pulse width modulator according to the state of the art as depicted in fig. 1.
In the diagram in fig. 2, the voltage V of a continuous amplitude input signal S, a pulse width modulated output signal SPWM and a sawtooth signal SR are plotted against the time t.
As soon as the ascending amplitude of the sawtooth signal SR has the same value as the continuous amplitude input signal S, the output of the comparator COMP in fig. 1 switches from voltage-high VH to voltage-low VL. As soon as the descending amplitude of the sawtooth signal SR has the same value as the input signal S, the output of the comparator COMP switches from voltage-low (VL) to voltage-high (VH). The output signal of the comparator COMP is the pulse width modulated signal SPWM comprising pulses of different length LP1-LP4.

Fig. 3 schematically shows an input signal which is a sampled version of a signal with a continuous amplitude, an output signal and a sawtooth reference signal of a pulse width modulator according to the state of the art.

In the diagram in fig. 3, the voltage V of a sampled version of the continuous amplitude input signal S, a pulse width modulated output signal SPWM and a sawtooth signal SR are plotted against the time t.

The generation of pulses LP1-LP4 is as described above in fig. 2 with the only difference that instead of a continuous amplitude input signal a sampled version of the continuous amplitude input signal S is used.

As already mentioned above, in order to achieve a wanted linear relation between an amplitude of an input signal S of a pulse width modulator and an output pulse width, a reference signal SR has to be a periodic triangular or sawtooth signal. However, such reference signals comprise spectral components at several multiples of the fundamental frequency of the reference signal SR and are difficult to generate and force extremely high bandwidth of the pulse width modulator and the subsequent amplifier stages.

It is therefore proposed to use a non-linear reference signal, as e.g. a sinusoidal reference signal, instead of a triangular or sawtooth signal. This relaxes the requirements on the reference signal generator and the analogue pulse width modulator.

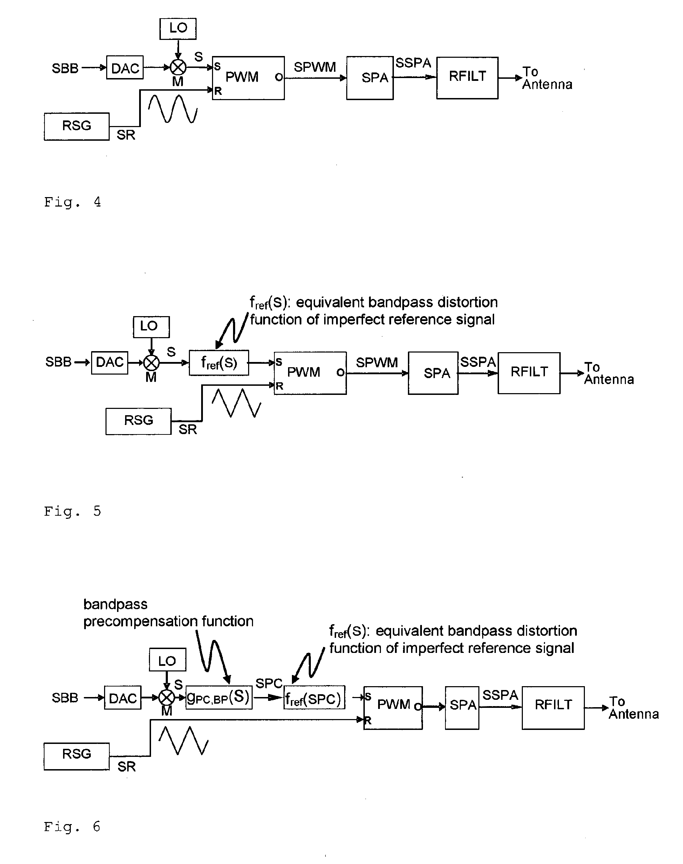

Fig. 4 schematically shows exemplarily a transmitter comprising a pulse width modulator using sinusoidal reference signals for signal modulation of an input signal.

The transmitter comprises a digital to analogue converter DAC, a mixer M, a local oscillator LO, a reference signal generator RSG, a pulse width modulator PWM, a switching power amplifier SPA, and a reconstruction filter RFILT.

An input signal on baseband level SBB is converted from digital to analogue domain in the digital to analogue converter DAC resulting in an analogue input signal on baseband level. In the local oscillator LO, a carrier frequency is generated, and in the mixer M, the analogue input signal on baseband level is upconverted on the carrier frequency resulting in an analogue input signal on carrier frequency S.

The analogue input signal on carrier frequency S is transmitted to a signal input of the pulse width modulator PWM, and a sinusoidal reference signal SR generated in the reference signal generator RSG is fed to a reference input of the pulse width modulator PWM. As depicted in figs. 1, 2 and 3, and described above, a pulse width modulated signal SPWM results from a comparison of the analogue input signal on carrier frequency S with the sinusoidal reference signal SR, and said pulse width modulated signal SPWM is sent to an input of the switching power amplifier SPA.

In the switching power amplifier SPA, said pulse width modulated signal SPWM, which is a binary, i.e. a 2-level, pulse width modulated signal, is amplified resulting in an amplified copy SSPA of the pulse width modulated signal SPWM.

The amplified copy SSPA of the pulse width modulated signal SPWM is then filtered in a reconstruction filter RFILT preferably of low pass or band pass type for converting the amplified copy SSPA of the pulse width modulated signal SPWM into an analogue signal, which is an amplified copy of the analogue input signal on carrier frequency S if signal distortions are corrected by a pre-emphasis of the analogue input signal on carrier frequency S.

However, a non-linear reference signal SR, as e.g. a sinusoidal signal, is an imperfect reference signal, since it causes a non-linear relation between the amplitude of the analogue input signal on carrier frequency S and the pulse width at the pulse width modulator output. With increasing modulation depth, i.e. decreasing peak power backoff (PBO), the non-linear distortions caused by the sinusoidal reference signal SR are growing and thus, deteriorate the quality of the transmit signal and the performance of the switch mode amplification concept as e.g. depicted in fig. 4. In other words, the acceptable peak power backoff range is lower bounded by the distortions caused by the reference signal SR. Consequently, the imperfect reference signal SR lowers the achievable coding efficiency of the pulse width modulator and thereby the energy efficiency of the whole switch mode amplification setup is reduced.

Thus, it is beneficial to use a non-linear, e.g. a sinusoidal, instead of a linear reference signal SR, as e.g a triangular or sawtooth signal, for the pulse width modulation, but the advantage of a non-linear reference signal SR of simpler signal generation comes at the cost of inband and out-of-band distortions, i.e. lower coding efficiency. Let consider the sinusoidal reference signal SR(t), with $A_{ref}$ being the magnitude and $f_{ref}$ being the frequency of the sinusoidal reference signal SR (t) :

$$SR(t) = A_{ref} \sin\left(2\pi f_{ref} t\right)$$

The block diagram of the corresponding transmission chain is depicted in fig. 4. The distortions introduced by the sinusoidal reference signal SR can be modelled by an equivalent bandpass distortion function $f_{ref}(S)$, modifying the upconverted information signal, with $S$ being the amplitude of the analogue input signal on carrier frequency S(t) and sgn(S) being the signum function, i.e. $\mathrm{sgn}(S) = \begin{cases} 1 & S \geq 0 \\ -1 & S < 0 \end{cases}$ :

$$f_{ref}(S) = \frac{2}{\pi} A_{ref} \arcsin\left(\frac{|S|}{A_{ref}}\right) \mathrm{sgn}(S)$$

By this means, the block diagram of the transmission chain with a sinusoidal reference signal SR as shown in fig. 4 can be modelled equivalently inserting the described distortion function $f_{ref}(S)$ in the transmission chain and using a triangular or sawtooth reference signal for pulse width modulation as depicted in fig. 5.

Fig. 5 schematically shows a transmitter comprising a pulse width modulator with a triangular reference signal with a modelling of bandpass distortions by sinusoidal reference signals performed by an equivalent bandpass distortion function $f_{ref}(S)$.

The transmitter as depicted in fig. 5 corresponds in principle to the transmitter depicted in fig. 4, so that in the following only the differences are explained.

Instead of a sinusoidal reference signal a triangular reference signal is used, and the distortions caused by the sinusoidal reference signal are instead modelled by a processing block in the signal path between the mixer M and the pulse width modulator PWM by the equivalent bandpass distortion function $f_{ref}(S)$.

The corresponding bandpass precompensation function $g_{PC,BP}(S)$ to precompensate the distortions caused by the sinusoidal reference signal is given by

$$g_{PC,BP}(S) = f_{ref}^{-1}(S) = A_{ref} \sin\left(\frac{\pi}{2} \frac{|S|}{A_{ref}}\right) \mathrm{sgn}(S) = \sum_{n=0}^{\infty} \alpha_{2n+1} |S|^{2n} S \ ,$$

where $a_n$ denotes the corresponding precompensation coefficients and
$a_n = 0 \ \forall \ n = 0,2,4,...$
because $g_{PC,BP}(S)$ is an odd function.

Fig. 6 schematically shows a transmitter comprising a pulse width modulator with a modelling of bandpass distortions by sinusoidal reference signals performed by an equivalent bandpass distortion function $f_{ref}(S)$, and with a modelling of a precompensation of the bandpass distortions performed by a bandpass precompensation function $g_{PC,BP}(S)$.

The transmitter as depicted in fig. 6 corresponds in principle to the transmitter depicted in fig. 5, so that in the following only the differences are explained.

In the transmitter depicted in fig. 6, the bandpass distortions caused by the sinusoidal reference signal are precompensated by a bandpass precompensation function $g_{PC,BP}(S)$ which is modelled by a processing block with the bandpass precompensation function $g_{PC,BP}(S)$ in the signal path between the mixer M and the processing block with the equivalent bandpass distortion function $f_{ref}(S)$. In other words, fig. 6 shows the transmission chain with the equivalent bandpass distortion function $f_{ref}(S)$ and the corresponding bandpass precompensation function $g_{PC,BP}(S)$.

Thus, the output signal SPC of the bandpass precompensation as depicted in fig. 6 can be written as

$$SPC(t) = g_{PC,BP}(S(t)) = \sum_{n=0}^{\infty} \frac{\alpha_{2n+1}}{2^{2n+1}} \left[SBB(t)\exp(j2\pi f_c t) + SBB^*(t)\exp(-j2\pi f_c t)\right]^{2n+1} \ ,$$

with $f_c$ being the carrier frequency.

This shows, that the bandpass precompensation introduces intermodulation products (IM) of the analogue input signal on carrier frequency and odd multiples of it, i. e. at $f_c$, $3f_c$, $5f_c$ ... .

By applying the bandpass precompensation as described above, any distortions caused by the sinusoidal reference signal are suppressed completely.

The drawback of the bandpass precompensation with the bandpass precompensation function $g_{PC,BP}(S)$ is, that it has to operate at very high frequencies because of the upconversion of the analogue input signal to carrier frequencies of usually several hundreds of MHz up to several GHz. This is a crucial problem since the bandpass precompensation can only be realized with sufficient accuracy using digital signal processing. However, digital signal processing and digital to analogue converters at such high frequencies are very difficult and costly.

Similar to the bandpass precompensation described beforehand, distortions due to the non-linear reference signal SR can be eliminated in the baseband. Due to the limited bandwidth of digital to analogue converters, the baseband precompensation can inherently only introduce intermodulation products to the input signal on baseband level, which are afterwards upconverted to the carrier frequency $f_c$. The baseband precompensation can not generate intermodulation products at odd multiples of the carrier frequency $f_c$ as the bandpass precompensation does. Therefore, the baseband precompensation can not compensate all distortions caused by the reference signal SR. However, due to the reconstruction filter RFILT after the switching power amplifier SPA, the compensation of inband distortions is sufficient.

One approach of the baseband precompensation is to generate the same inband intermodulation products, which would be introduced by the bandpass precompensation as described above.

Focusing only on the inband spectral components, i.e. the spectral components in the vicinity of the carrier frequency $f_c$, the precompensated signal SPC after the bandpass precompensation can be written as

$$SPC(t) = g_{PC,BP}(S(t)) = \sum_{n=0}^{\infty} \frac{\alpha_{2n+1}b_n}{2^{2n}} |SBB(t)|^{2n} \frac{1}{2} \left( SBB(t)\exp(j2\pi f_c t) + SBB^*(t)\exp(-j2\pi f_c t) \right) + \cdots$$

with the binomial coefficients $b_n$

$$b_n = \binom{2n+1}{n} = \begin{cases} 1 & for \quad n=0 \\ 3 & for \quad n=1 \\ 10 & for \quad n=2 \\ 35 & for \quad n=3 \\ \vdots & \end{cases}.$$

Therefore, by formulating the baseband precompensation function $g_{PC,BB}(SBB)$ as

$$g_{PC,BB}(SBB) = \sum_{n=0}^{\infty} \beta_{2n+1} |SBB|^{2n} SBB$$

with the baseband precompensation coefficients

$$\beta_{2n+1} = \frac{b_n}{2^{2n}} \alpha_{2n+1}, \quad \beta_{2n} = 0, \quad n = 0,1,2,\cdots$$

the same inband intermodulation products are generated as the bandpass precompensation would introduce.

This approach of the baseband precompensation improves drastically the transmitter performance and the adjacent channel leakage ratio (ACLR). This can be used for extending the used dynamic range of the pulse width modulator device, which enhances the coding efficiency significantly.

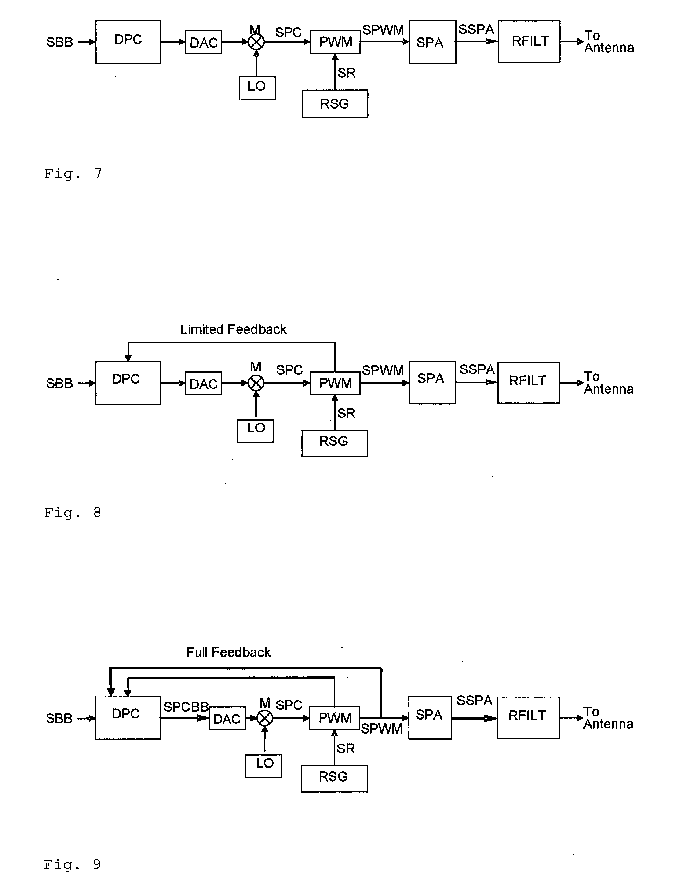

Fig. 7 schematically shows a transmitter comprising a precompensation unit for baseband precompensation, a pulse width modulator for signal modulation, and a switching power amplifier.

The transmitter as depicted in fig. 7 corresponds in principle to the transmitter depicted in fig. 4, so that in the following only the differences are explained.

The transmitter comprises in addition to the transmitter of fig. 4 a precompensation unit DPC in the signal path before the digital to analogue converter DAC.

An input signal on baseband level SBB is modified applying baseband precompensation by means of the baseband precompensation function $g_{PC,BB}(SBB)$ as described above, so that distortions caused by imperfections of the reference signal in the vicinity of the input signal on carrier frequency vanish after the pulse width modulation. The resulting precompensated input signal on baseband level is converted from digital to analogue domain in the digital to analogue converter DAC resulting in an analogue precompensated input signal on baseband level. In the local oscillator LO, a carrier frequency is generated, and in the mixer M, the analogue precompensated input signal on baseband level is upconverted on the carrier frequency resulting in an analogue precompensated input signal on carrier frequency SPC.

The further signal processing is as described above under fig. 4.

In order to demonstrate the capabilities of the baseband precompensation, some measurement results and simulation results are presented. A clipped 3GPP UMTS so-called Testmodel 3 signal (3GPP = Third Generation Partnership Project; UMTS = Universal Mobile Telecommunications System) with a peak to average power ratio (PAPR) of 5.6dB is used. The maximum coding efficiency is determined, while the transmitter chain still meets the 3GPP UMTS specification, i.e. ACLR1 ($f_c \pm 5$MHz) $\geq 45$dB and ACLR2 ($f_c \pm 10$MHz) $\geq 50$dB (ACLR = Adjacent Channel Leakage Power Ratio).

Measurement results:

The following devices and parameters have been used:

- Binary, i.e. 2-level, pulse width modulator with switching power amplifier, i.e. a Class-S current mode power amplifier.

- Reference signal frequency of the pulse width modulator: $f_{ref}$=1850MHz

- Carrier frequency: $f_c$=800MHz

In the following table, the measured coding efficiencies for sinusoidal reference signals with and without precompensation on baseband level are compared.

| | Binary PWM with switching power amplifier (Class-S current mode power amplifier) | |
|---|---|---|
| | PWM Reference Signal | Max. Coding Efficiency |
| without precompensation | sinusoidal | 2.6% |
| baseband precompensation | sinusoidal | 11.2% |

Simulation results:

The following devices and parameters have been used:

- Binary, i.e. 2-level, pulse width modulator

- Reference signal frequency of the pulse width modulator: $f_{ref}$=2GHz

- Carrier frequency: $f_c$=900MHz

In the following table, the simulated coding efficiencies for sinusoidal reference signals with and without precompensation on baseband level are compared. For comparison reasons the coding efficiency for the case of a triangular reference signal is given, since it assures a linear transfer characteristic of the PWM device and thus defines the upper bound of such PWM modulation.

| | Binary PWM | |
|---|---|---|
| | PWM Reference Signal | Max. Coding Efficiency |
| Benchmark (upper bound) | triangular | 13.6% |
| without precompensation | sinusoidal | 2.6% |
| baseband precompensation | sinusoidal | 12.0% |

Based on these results, the following conclusions can be drawn:

By using the baseband precompensation to elimiate the distortions caused by a sinusoidal reference signal, almost the same coding efficiency can be achieved as in the case of a triangular reference signal, which represents the upper bound for radio frequency pulse width modulators.

Considering the results for a binary pulse width modulator, the coding efficiencies predicted by simulations are verified by the measurement results. This approves and demonstrates the huge potential of the proposed baseband precompensation to eliminate the distortions introduced by the non-linear reference signal.

More generally, a baseband precompensation, as e.g. performed by the precompensation unit DPC in fig. 7, can be categorized into three different types, according to the degree of accuracy the pulse width modulator PWM can be observed by the precompensation unit DPC.

The first type of baseband precompensation can be seen as a kind of blind baseband precompensation. The baseband precompensation is adjusted to parameters of a designed pulse width modulator device and reference signal source. Based on the knowledge of the reference signal type and the designed power of the reference signal, the equivalent bandpass distortion function $f_{ref}(SPC)$ and the corresponding bandpass precompensation function $g_{PC,BP}(S)$ can be calculated. Afterwards the bandpass precompensation coefficients $\alpha_n$ are calculated from $g_{PC,BP}(S)$ and thus the baseband precompensation coefficients are given by

$$\beta_{2n+1} = \frac{b_n}{2^{2n}}\alpha_{2n+1}, \quad \beta_{2n} = 0, \quad n = 0,1,2,\cdots .$$

Furthermore, if imperfections of the designed pulse width modulator device are known, e.g. as result of circuit simulations of the pulse width modulator device or as a result of a calibration procedure of several samples of the pulse width modulator device, they can be incorporated in the equivalent bandpass distortion function $f_{ref}(SPC)$. Thus, the baseband precompensation coefficients $\beta_n$ are adapted correspondingly, as described in the previous paragraph. However, this type of baseband precompensation does neither adapt to the specific parameters of the considered pulse width modulator device sample nor to changing pulse width modulator device parameters, e.g. due to temperature shifts or aging.

An example for implementation of said first type of baseband precompensation is shown in fig. 7, which is described above.

The second type of baseband precompensation can be seen as a kind of baseband precompensation with limited feedback. Key parameters of the reference signal SR and the pulse width modulator are measured and are fed back from the pulse width modulator to the precompensation unit DPC. Possible parameters can be a peak amplitude of the reference signal SR and several parameters of the pulse width modulator PWM, as e.g. a temperature, and a power supply voltage of the pulse width modulator PWM.

An example for implementation of said second type of baseband precompensation is shown in fig. 8.

Fig. 8 schematically shows a transmitter comprising a precompensation unit, a pulse width modulator for signal modulation, and a switching power amplifier with feedback of information from the pulse width modulator to the precompensation unit.

The transmitter as depicted in fig. 8 corresponds in principle to the transmitter depicted in fig. 7, so that in the following only the differences are explained.

The transmitter comprises in addition to the transmitter of fig. 7 a feedback from the pulse width modulator PWM to the precompensation unit DPC for feedback of measurement values of characteristic parameters of the designed pulse width modulator PWM, or the reference signal SR, as e.g. the measured peak or average power of the reference signal, the measured temperature and measured power supply voltage of the pulse width modulator device. Employing a calibration of the pulse width modulator device sample before its use in the transmitter, the impact of these parameters on the pulse width modulation operation of this sample can be determined. Based on this the resulting equivalent bandpass distortion function $f_{ref}(SPC)$ of this pulse width modulator device and the corresponding bandpass precompensation functions and coefficients can be calculated.

$$g_{PC,BP}(S) = f_{ref}^{-1}(S) = \sum_{n=0}^{\infty} \alpha_{2n+1}|S|^{2n}S$$

By this, the baseband precompensation coefficients can be calculated by

$$\beta_{2n+1} = \frac{b_n}{2^{2n}}\alpha_{2n+1}, \quad \beta_{2n} = 0, \quad n = 0,1,2,\cdots .$$

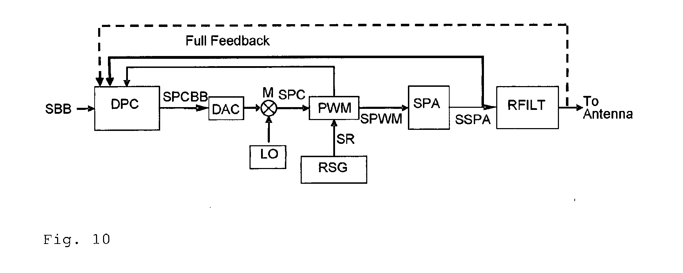

The third type of baseband precompensation can be seen as a kind of baseband precompensation with full feedback. Additional to the feedback of specific key parameters of the reference signal SR and the pulse width modulator PWM as depicted in fig. 8 and described above, the precompensation unit DPC observes either the output signal of the pulse width modulator PWM, i.e. the pulse width modulated signal SPWM, as depicted in fig. 9, or the output of the switching power amplifier SPA. i.e. the amplified copy SSPA of the pulse width modulated signal SPWMA, as depicted in fig. 10, through a second feedback path.

Fig. 9 schematically shows a transmitter comprising a precompensation unit, a pulse width modulator for signal modulation, and a switching power amplifier with feedback of information from the pulse width modulator to the precompensation unit, and with feedback of a pulse width modulated signal to the precompensation unit.

The transmitter as depicted in fig. 9 corresponds in principle to the transmitter depicted in fig. 8, so that in the following only the differences are explained.

The transmitter comprises in addition to the transmitter of fig. 8 a feedback from the output of the pulse width modulator PWM to the precompensation unit DPC for feedback of a pulse width modulated signal SPWM to the precompensation unit DPC.

Fig. 10 schematically shows a transmitter comprising a precompensation unit, a pulse width modulator for signal modulation, and a switching power amplifier with feedback of information from the pulse width modulator to the precompensation unit, and with feedback of an amplified pulse width modulated signal to the precompensation unit.

The transmitter as depicted in fig. 10 corresponds in principle to the transmitter depicted in fig. 8, so that in the following only the differences are explained.

The transmitter comprises in addition to the transmitter of fig. 8 a feedback from the output of the switching power amplifier SPA to the precompensation unit DPC for feedback of an amplified pulse width modulated signal SSPA to the precompensation unit DPC.

The embodiments described in figs. 9 and 10 allow for tracking the overall transfer characteristic of the pulse width modulation, i.e. input amplitude to output pulse width relationship of the pulse width modulator, and thus enables the baseband precompensation, i.e. the precompensation unit DPC, to be adapted online to the characteristics of the pulse width modulation. By this means variations of the pulse width modulation transfer characteristic, due to e.g. sample variations as a consequence of production tolerances, temperature shifts, supply voltage variations, aging effects, are taken into account and are compensated online by the digital baseband precompensation in the precompensation unit DPC. For this purpose, the feedback signal can be down-mixed with the carrier frequency to baseband and lowpass filtered. Since the processing of the feedback signal does not differ for the feedback of a pulse width modulated signal SPWM or an amplified pulse width modulated signal SSPA the following explanations focus on the feedback processing of SSPA. Let denote the downmixed and low-pass filtered feedback signal by SFB. After a time synchronization of the feedback signal, the precompensated baseband signal SPCBB is interpreted as a nonlinear copy of the feedback signal SFB:

$$SPCBB = \sum_{n=0}^{\infty} \gamma_{2n+1} |SFB|^{2n} SFB \; ,$$

where the coefficients $\gamma_n$ equal the required baseband precompensation coefficients $\beta_n = \gamma_n$. Thus, the coefficients $\gamma_n$ need to be calculated based on blocks of the feedback signal SFB and the precompensated baseband signal SPCBB. The digital precompensation block is then adjusted according to $\beta_n = \gamma_n$, i.e. it contains the nonlinear mapping function

$$g_{PC,BB}(SBB) = \sum_{n=0}^{\infty} \beta_{2n+1} |SBB|^{2n} SBB \; .$$

In an alternative of the embodiment depicted in fig. 10, instead of a feedback from the output of the switching power amplifier SPA to the precompensation unit DPC, the transmitter comprises a feedback from the output of the reconstruction filter RFILT to the precompensation unit DPC for feedback of the amplified pulse width modulated signal SSPA after conversion in the analogue domain to the precompensation unit DPC, which is indicated by a dashed arrow in fig. 10.

A base station in a wireless communication network can comprise such a transmitter as described in one of the embodiments above, and an antenna network for transmission of signals over an air interface.

**Claims**

1. A method for pulse width modulation, wherein

   • a non-linear reference signal (SR) is used for the pulse width modulation, **characterized in that**
   • a signal (SBB) is precompensated before the pulse width modulation for compensation of distortions due to at least the non-linear reference signal (SR) resulting in a precompensated signal (SPC),
   • the signal (SBB) is precompensated by introduction of at least one intermodulation product of the signal (SBB) on at least one of a carrier frequency and odd multiples of said carrier frequency resulting in the precompensated signal (SPC),
   • and the precompensated signal (SPC) which is upconverted on the carrier frequency is pulse width modulated using said non-linear reference signal (SR) for the pulse width modulation resulting in a pulse width modulated signal (SPWM).

2. A method according to claim 1, wherein the signal (SBB) is first upconverted on the carrier frequency and then precompensated resulting in the precompensated signal (SPC).

3. A method according to claim 1, wherein the signal (SBB) is first precompensated in the baseband and then upconverted on the carrier frequency resulting in the precompensated signal (SPC).

4. A method according to claim 3, wherein the signal (SBB) is precompensated by introduction of at least one intermodulation product of the signal (SBB) on the carrier frequency.

5. A method according to claim 1, wherein the non-linear reference signal (SR) is a sinusoidal reference signal, and the signal (SBB) is precompensated by introduction of at least one intermodulation product of the signal (SBB) on at least one of a carrier frequency and odd multiples of said carrier frequency resulting in the precompensated signal (SPC).

6. A method according to any of the preceding claims, wherein the signal (SBB) is precompensated based on at least one of a-priori known device imperfections and a power of the non-linear reference signal (SR).

7. A method according to any of the preceding claims, wherein the signal (SBB) is precompensated based on at least one of a peak amplitude of the non-linear reference signal (SR), a temperature of a pulse width modulator, and a power supply voltage of the pulse width modulator.

8. A method according to any of the preceding claims, wherein the signal (SBB) is precompensated based on at least one of the pulse width modulated signal (SPWM), and an amplified pulse width modulated signal (SSPA).

9. A method according to any of the preceding claims, wherein said non-linear reference signal (SR) is a sinusoidal signal.

10. A transmitter comprising at least one precompensation unit (DPC), and at least one pulse width modulator (PWM), wherein

    • at least one of said at least one pulse width modulator (PWM) is adapted to use a non-linear reference signal (SR) for pulse width modulation, **characterized in that**
    • at least one of said at least one precompensation unit (DPC) is adapted to precompensate a signal (SBB) before pulse width modulation for compensation of distortions due to at least the non-linear reference signal (SR) resulting in a precompensated signal (SPC),
    • said at least one of said at least one precompensation unit (DPC) is adapted to precompensate the signal (SBB) by introduction of at least one intermodulation product of the signal (SBB) on at least one of a carrier frequency and odd multiples of said carrier frequency resulting in the precompensated signal (SPC),
    • and the at least one of said at least one pulse width modulator (PWM) is adapted to pulse width modulate the precompensated signal (SPC) which is upconverted on the carrier frequency using said non-linear reference signal (SR) for the pulse width modulation resulting in a pulse width modulated signal (SPWM).

11. A transmitter according to claim 10, wherein the transmitter comprises.a switching power amplifier for amplification of the pulse width modulated signal (SPWM).

12. A base station comprising a transmitter according to claim 11 and at least one antenna network for transmission of said signals over an air interface.

**Patentansprüche**

1. Verfahren zur Pulsweitenmodulation, wobei

   • ein nichtlineares Referenzsignal (SR) für die Pulsweitenmodulation verwendet wird,
   **dadurch gekennzeichnet, dass**
   • ein Signal (SBB) vor der Pulsweitenmodulation vorkompensiert wird, um durch mindestens ein nichtlineares Referenzsignals (SR) verursachte Verzerrungen zu kompensieren, wodurch ein vorkompensiertes Signal (SPC) entsteht,
   • das Signal (SBB) durch Einbringen mindestens eines Intermodulationsproduktes des Signals (SBB) auf mindestens entweder einer Trägerfrequenz oder auf ungeradzahligen Vielfachen der besagten Trägerfrequenz vorkompensiert wird, wodurch das vorkompensierte Signal (SPC) entsteht,
   • und dass das vorkompensierte Signal (SPC), welches auf der Trägerfrequenz aufwärtskonvertiert wird, unter Verwendung des besagten nichtlinearen Referenzsignals (SR) für die Pulsweitenmodulation pulsweitenmoduliert wird, wodurch ein pulsweitenmoduliertes Signal (SPWM) entsteht.

2. Verfahren nach Anspruch 1, wobei das Signal (SBB) zuerst auf der Trägerfrequenz aufwärtskonvertiert und anschließend vorkompensiert wird, wodurch das vorkompensierte Signal (SPC) entsteht.

3. Verfahren nach Anspruch 1, wobei das Signal (SBB) zuerst im Basisband vorkompensiert und anschließend auf der Trägerfrequenz aufwärtskonvertiert wird, wodurch das vorkompensierte Signal (SPC) entsteht.

4. Verfahren nach Anspruch 3, wobei das Signal (SBB) durch Einbringen mindestens eines Intermodulationsproduktes des Signals (SBB) auf der Trägerfrequenz vorkompensiert wird.

5. Verfahren nach Anspruch 1, wobei das nichtlineare Referenzsignal (SR) ein sinusförmiges Referenzsignal ist, und wobei das Signal (SBB) durch Einbringen mindestens eines Intermodulationsproduktes des Signals (SBB) auf zumindest entweder einer Trägerfrequenz oder auf ungeradzahligen Vielfachen der besagten Trägerfrequenz vorkompensiert wird, wodurch das vorkompensierte Signal (SPC) entsteht.

6. Verfahren nach einem beliebigen der vorstehenden Ansprüche, wobei das Signal (SBB) auf der Basis mindestens entweder von im Voraus bekannten Vorrichtungsimperfektionen oder einer Leistung des nichtlinearen Referenzsignals (SR) vorkompensiert wird.

7. Verfahren nach einem beliebigen der vorstehenden Ansprüche, wobei das Signal (SBB) auf der Basis mindestens entweder einer Spitzenamplitude des nichtlinearen Referenzsignals (SR), einer Temperatur eines Pulsweitenmodulators oder einer Stromversorgungsspannung des Pulsweitenmodulators vorkompensiert wird.

8. Verfahren nach einem beliebigen der vorstehenden Ansprüche, wobei das Signal (SBB) auf der Basis mindestens entweder des pulsweitenmodulierten Signals (SPWM) oder eines verstärkten pulsweitenmodulierten Signals (SSPA) vorkompensiert wird.

9. Verfahren nach einem beliebigen der vorstehenden Ansprüche, wobei das nichtlineare Referenzsignal (SR) ein sinusförmiges Signal ist.

10. Sender mit mindestens einer Vorkompensationseinheit (DPC) und mindestens einem Pulsweitenmodulator (PWM), wobei

   • zumindest einer des besagten mindestens einen Pulsweitenmodulators (PWM) für die Verwendung eines nichtlinearen Referenzsignal (SR) für die Pulsweitenmodulation ausgelegt ist,
   **dadurch gekennzeichnet, dass**
   • mindestens eine der besagten mindestens einen Vorkompensationseinheit (DPC) für das Vorkompensieren eines Signals (SBB) vor der Pulsweitenmodulation ausgelegt ist, um durch mindestens ein nichtlineares Referenzsignal (SR) verursachte Verzerrungen zu kompensieren, wodurch ein vorkompensiertes Signal (SPC) entsteht,

• die besagte zumindest eine der besagten mindestens einen Vorkompensationseinheit (DPC) für das Vorkompensieren des Signals (SBB) durch Einbringen mindestens eines Intermodulationsproduktes des Signals (SBB) auf mindestens entweder einer Trägerfrequenz oder auf ungeradzahligen Vielfachen der besagten Trägerfrequenz ausgelegt ist, wodurch das vorkompensierte Signal (SPC) entsteht,

• und dass zumindest einer des besagten mindestens einen Pulsweitenmodulators (PWM) für die Pulsweitenmodulation des vorkompensierten Signals (SPC), welches auf der Trägerfrequenz aufwärtskonvertiert wird, unter Verwendung des besagten nichtlinearen Referenzsignals (SR) für die Pulsweitenmodulation ausgelegt ist, wodurch ein pulsweitenmoduliertes Signal (SPWM) entsteht.

11. Sender nach Anspruch 10, wobei der Sender einen Schaltleistungsverstärker für die Verstärkung des pulsweitenmodulierten Signals (SPWM) umfasst.

12. Basisstation, umfassend einen Sender gemäß Anspruch 11, und mindestens ein Antennennetzwerk zur Übertragung der besagten Signale über eine Luftschnittstelle.


**Revendications**

1. Procédé de modulation de largeur d'impulsion, dans lequel

• un signal non-linéaire de référence (SR) est utilisé pour la modulation de largeur d'impulsion,
**caractérisé en ce que**
• un signal (SBB) est précompensé avant la modulation de largeur d'impulsion pour compenser les distorsions dues au moins au signal non-linéaire de référence (SR) ce qui a pour résultat un signal précompensé (SPC),
• le signal (SBB) est précompensé par l'introduction d'au moins un produit d'intermodulation du signal (SBB) au moins sur une fréquence parmi une fréquence porteuse et des multiples impairs de ladite fréquence porteuse ce qui a pour résultat le signal précompensé (SPC),
• et le signal précompensé (SPC) qui est élevé en fréquence sur la fréquence porteuse est modulé en largeur d'impulsion au moyen dudit signal non-linéaire de référence (SR) pour la modulation de largeur d'impulsion ce qui a pour résultat un signal à modulation de largeur d'impulsion (SPWM).

2. Procédé selon la revendication 1, dans lequel le signal (SBB) est d'abord élevé en fréquence sur la fréquence porteuse puis précompensé ce qui a pour résultat le signal précompensé (SPC).

3. Procédé selon la revendication 1, dans lequel le signal (SBB) est d'abord précompensé dans la bande de base puis élevé en fréquence sur la fréquence porteuse ce qui a pour résultat le signal précompensé (SPC).

4. Procédé selon la revendication 3, dans lequel le signal (SBB) est précompensé par l'introduction d'au moins un produit d'intermodulation du signal (SBB) sur la fréquence porteuse.

5. Procédé selon la revendication 1, dans lequel le signal non-linéaire de référence (SR) est un signal de référence sinusoïdal, et le signal (SBB) est précompensé par l'introduction d'au moins un produit d'intermodulation du signal (SBB) au moins sur une fréquence parmi une fréquence porteuse et des multiples impairs de ladite fréquence porteuse ce qui a pour résultat le signal précompensé (SPC).

6. Procédé selon l'une quelconque des revendications précédentes, dans lequel le signal (SBB) est précompensé en se basant sur au moins une parmi des imperfections de dispositif à priori connues et une puissance du signal non-linéaire de référence (SR).

7. Procédé selon l'une quelconque des revendications précédentes, dans lequel le signal (SBB) est précompensé en se basant sur au moins un élément parmi une amplitude de crête du signal non-linéaire de référence (SR), une température d'un modulateur de largeur d'impulsion et une tension d'alimentation du modulateur de largeur d'impulsion.

8. Procédé selon l'une quelconque des revendications précédentes, dans lequel le signal (SBB) est précompensé en se basant sur au moins un signal parmi le signal à modulation de largeur d'impulsion (SPWM) et un signal à modulation de largeur d'impulsion amplifié (SSPA).

**9.** Procédé selon l'une quelconque des revendications précédentes, dans lequel ledit signal non-linéaire de référence (SR) est un signal sinusoïdal.

**10.** Émetteur comprenant au moins une unité de précompensation (DPC), et au moins un modulateur de largeur d'impulsion (PWM), dans lequel

• au moins un dudit ou desdits modulateurs de largeur d'impulsion (PWM) est adapté pour utiliser un signal non-linéaire de référence (SR) pour la modulation de largeur d'impulsion,
**caractérisé en ce que**
• au moins une de ladite ou desdites unités de précompensation (DPC) est adaptée pour précompenser un signal (SBB) avant la modulation de largeur d'impulsion pour compenser les distorsions dues au moins au signal non-linéaire de référence (SR) ce qui a pour résultat un signal précompensé (SPC),
• ladite au moins une de ladite ou desdites unités de précompensation (DPC) est adaptée pour précompenser le signal (SBB) en introduisant au moins un produit d'intermodulation du signal (SBB) au moins sur une fréquence parmi une fréquence porteuse et des multiples impairs de ladite fréquence porteuse ce qui a pour résultat le signal précompensé (SPC),
• et l'au moins un dudit ou desdits modulateurs de largeur d'impulsion (PWM) est adapté pour moduler en largeur d'impulsion le signal précompensé (SPC) qui est élevé en fréquence sur la fréquence porteuse au moyen dudit signal non-linéaire de référence (SR) pour la modulation de largeur d'impulsion ce qui a pour résultat un signal à modulation de largeur d'impulsion (SPWM).

**11.** Émetteur selon la revendication 10, dans lequel l'émetteur comprend un amplificateur de puissance à commutation pour amplifier le signal à modulation de largeur d'impulsion (SPWM).

**12.** Station de base comprenant un émetteur selon la revendication 11 et au moins un réseau d'antennes pour la transmission desdits signaux sur une interface radio.

Fig. 1

Fig. 2

Fig. 3

EP 2 608 410 B1

Fig. 4

Fig. 5

Fig. 6

16

Fig. 7

Fig. 8

Fig. 9

Fig. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3363199 A
- US 20090027117 A1
- WO 8204507 A1
- WO 2006020503 A2